# EUROPEAN PATENT SPECIFICATION

(11) **EP 2 372 775 B1**
(45) Date of publication and mention of the grant of the patent: **19.10.2016**
(21) Application number: 11158022.1
(22) Date of filing: 14.03.2011
(51) Int. Cl.: H01L 31/0224

(54) **Electrode structure of solar cell**
Elektrodenstruktur einer Solarzelle
Structure d'électrode de cellule solaire

(30) Priority: 29.03.2010 TW 099205462
(43) Date of publication of application: 05.10.2011
(73) Proprietor: Neo Solar Power Corp., Hsinchu City 300 (TW)
(72) Inventor: Wu, Meng-Hsiu, 300 Hsinchu City (TW); Tai, Yu-Wei, 300 Hsinchu City (TW); Chen, Yang-Fang, Hsinchu City 300 (TW)
(74) Representative: 2K Patentanwälte Blasberg Kewitz & Reichel

(56) References cited:
- WO-A1-2010/001473
- JP-A- 6 053 531
- US-A1- 2007 209 697
- US-A1- 2010 018 577

## Description

### BACKGROUND OF THE INVENTION

### Field of Invention

The present invention relates to an electrode structure and, in particular, to an electrode structure for a solar cell.

### Related Art

The manufacture of silicon wafers is a very developed technology, and it is widely applied to the various semiconductor products. In addition, the energy gap of the silicon atoms is suitable for absorbing solar energy, so that the silicon solar cell has become the most popular solar cell. In generally, the structure of the single-crystal or poly-crystal silicon solar cell usually includes the following layers of: an external electrode, an anti-reflective layer, an N-type semiconductor layer, a P-type semiconductor layer, and a back contact electrode.

When the N-type semiconductor layer contacts with the P-type semiconductor layer, the electrons in the N-type semiconductor layer flow into the P-type semiconductor layer to fill the holes in the P-type semiconductor layer. Accordingly, the combination of the electrons and holes generates a polar depletion region around the P-N junction. In addition, the N-type semiconductor layer and the P-type semiconductor layer, which carry the negative and positive charges respectively, can generate an internal electric field. When the solar light reaches the P-N structure, the P-type semiconductor and the N-type semiconductor layer can absorb the energy of the solar light to generate the electron-hole pairs. Then, the internal electric fields in the depletion region can drive the generated electron-hole pairs to induce the electron flow inside the semiconductor layers. If the electrodes are properly applied to output the electrons, the solar cell can operate.

The external electrode is usually made of nickel, silver, aluminum, copper, palladium, and their combinations. In order to output sufficient amount of the electron flow, a large conductive surface between the electrodes and the substrate is needed. However, the surface area of the substrate covered by the external electrode should be as small as possible so as to decrease the obscuring rate of the solar light caused by the external electrode. Therefore, the design of the external electrode structure should satisfy both the properties of low resistance and low obscuring rate.

Accordingly, the external electrode structure usually includes the bus electrode and the finger electrode. The cross-sectional area of the bus electrode is larger than that of the finger electrode. The bus electrode is the main body, and the finger electrodes are branched from the bus electrode and distributed all over the surface of the solar cell. Thus, the electrons can be collected by the finger electrodes and then transmitted to the external load through the bus electrode. In other words, the bus electrode with larger dimension is help for increasing the electron flow, and the finger electrodes with smaller dimension are help for decreasing the light obscuring rate.

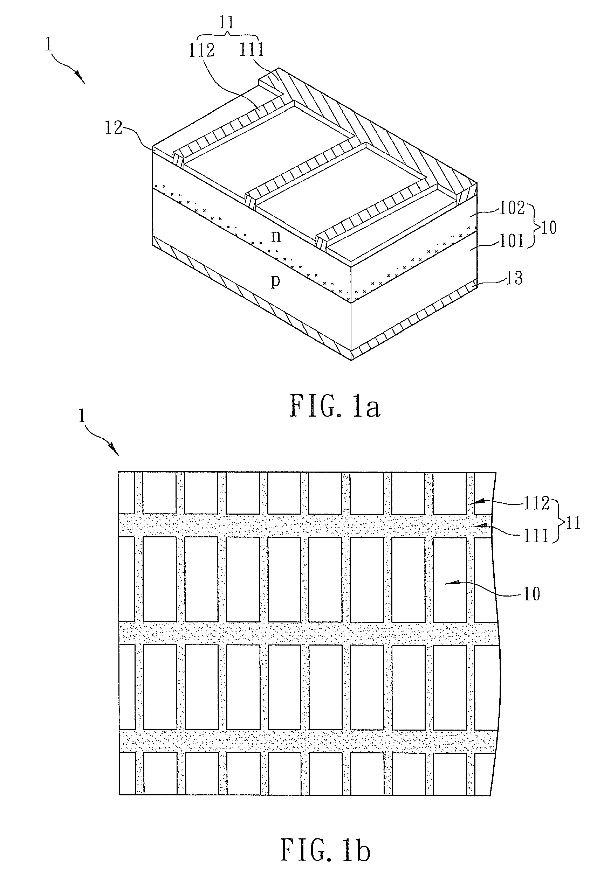

FIG. 1a is a schematic diagram of a conventional solar cell 1, and FIG. 1b is the top view of the electrode structure of the conventional solar cell 1. To be noted, FIG. 1a only shows one bus electrode for concise purpose. As shown in FIGS. 1a and 1b, a substrate 10 is constructed by a P-type semiconductor layer 101 and an N-type semiconductor layer 102. A bus electrode 111 and a plurality of finger electrodes 112 are formed by screen printing process on a surface of the substrate 10, which is used for receiving light. The bus electrode 111 and the finger electrodes 112 together form the electrode structure 11. The electrons are collected from the finger electrodes 112 to the bus electrode 111, and then the bus electrode 111 can output the electrons. An anti-reflective layer 12 is disposed on the surface of the substrate 10. The material of the anti-reflective layer 12 includes silicon nitride, so that the anti-reflective layer 12 can be transparent for decreasing the reflection so as to increase the photo-electro transition rate. In addition, the rear surface of the substrate 10 is covered by a back contact electrode 13, which is coupled to the electrode structure 11 for providing electricity to the external load or power storage.

In general, the electrode structure is formed by the screen printing process. By several times of screen printing, the bus electrodes and finger electrodes are simultaneously formed on the substrate with the same thickness. Compared with the bus electrodes with larger width, the finger electrodes have smaller width, so that their resistance is higher. This is an impediment to the transmission of the electron flow.

Therefore, it is an important subject of the present invention to provide an electrode structure of the solar cell that can reduce the resistance of the finger electrode so as to increase the conductivity and can still remain the low light obscuring rate so as to keep the efficiency of photo-electro transition.
US 2007 209697 A discloses an electrode structure for a solar cell according to the preamble of claim 1. A solar cell manufacturing method for forming an electrode of a predetermined pattern repeats printing on a substrate surface by a predetermined number of times. The silver bus electrode and the silver grid electrode are firstly formed by a first screen printing process using a mask pattern which includes a bus-electrode mask pattern and a grid-electrode mask pattern. Then, a second screen printing process is performed with the use of a mask pattern which only includes the grid-electrode mask pattern.

WO 2010001473 A relates to a photovoltaic system which is capable of equalizing the width of a front surface electrode generated in the condition of fast baking to that of a conventional one which is not generated in the condition. The photovoltaic system has a p-type silicon substrate, an n-type diffused layer generated on the light incident surface side of the p-type silicon substrate, front surface electrodes generated on the n-type diffused layer, a p+ layer generated on a rear surface opposite to the light incident surface of the p-type silicon substrate, and a rear surface electrode generated at predetermined positions on the p+ layer. The front surface electrodes respectively have a first electrode layer generated on the n-type diffused layer and at least one second electrode layer generated on the first electrode layer and having a specific resistance smaller than that of the first electrode layer. However, the first electrode layer and the second electrode layer have the same width.

### SUMMARY OF THE INVENTION

It is an object of the present invention to provide an enhanced electrode structure of a solar cell that has reduced resistance, low light obscuring rate and can be manufactured at reduced costs.

This problem is solved by an electrode structure according to claim 1. Further advantageous embodiments are the subject-matter of the dependent claims. According to the present invention the electrode structure of a solar cell is formed by multiple screen printing processes, wherein at least one of the screen printing processes does not form the bus electrodes. Thus, the manufacturing cost can be decreased.

The electrode structure of the present invention is disposed on a substrate of a solar cell. The electrode structure includes a plurality of bus electrodes and a plurality of finger electrodes. The bus electrodes are separately disposed on the substrate. The finger electrodes are disposed on two sides of the bus electrodes and electrically connected to the bus electrodes. According to the present invention the finger electrodes comprise first finger electrodes and second finger electrodes disposed on the top of said first finger electrodes, wherein the width of the second finger electrodes is smaller than the width of the first finger electrodes such that the thickness of the finger electrodes is larger than that of the bus electrodes. Thus, the bus electrodes and the finger electrodes are formed by at least two screen printing processes, and at least one of the screen printing processes does not form the bus electrodes.

Because the finger electrodes consist of first finger electrodes and second finger electrodes disposed on the top of said first finger electrodes, the thicknesses of finger electrodes are larger than those of the bus electrodes.

In one embodiment of the present invention, the dimension of one end (e.g. a first end) of the finger electrode contact with the bus electrode is larger than the dimension of the other end (e.g. a second end) of the finger electrode away from the bus electrode. Each finger electrode has a taper shape with the first end larger than the second end, so that it has a trapezoid shape for example.

In one embodiment of the present invention, the finger electrodes are formed by at least two screen printing processes to form the same or different patterns, shapes or dimensions.

The electronic property of the solar cell is sufficiently related to the light utility and the electron transmission resistance. In the prior art, the external electrode is formed on the substrate of the solar cell by screen printing processes, and it includes a plurality of bus electrodes and a plurality of finger electrodes. The material of the external electrode usually includes silver or silver-aluminum slurry, which is then sintered by high temperature. The formed external electrode can collect the electron flow after the photo-electro transition. However, a single screen printing process can not perfectly form the external electrode with the desired height. That is because the printed silver or silver-aluminum slurry is not solid before the high-temperature sintering. If the height and surface area of the printed silver or silver-aluminum slurry are too large, the lower liquid slurry can not support the upper slurry. Thus, the upper slurry may flow toward two sides, and the desired pattern (e.g. the rectangular net distribution) for reducing the contact area with the substrate and lowering the light obscuring rate can not be formed. Accordingly, multiple repeated screen printing and high-temperature sintering are needed to form the external electrode with the desired thickness.

As mentioned above, in the electrode structure of the solar cell of the present invention, the bus electrodes and the finger electrodes are formed by at least two screen printing processes, and at least one of the screen printing processes does not form the bus electrodes. Thus, the relative thicknesses of the finger electrodes and the bus electrodes can be controlled. In this invention, the thickness of the finger electrodes is larger than that of the bus electrodes, so that the resistance of the finger electrodes can be decreased and the conductivity thereof can be increased. In addition, because at least one of the screen printing processes does not form the bus electrodes, the manufacturing cost of the electrode structure can be reduced. Compared with the prior art, the present invention modifies the screen printing processes so as to achieve the lower light obscuring rate and resistance, thereby efficiently increasing the photo-electro transition rate of the solar cell.

### BRIEF DESCRIPTION OF THE DRAWINGS

The invention will become more fully understood from the detailed description and accompanying drawings, which are given for illustration only, and thus are not limitative of the present invention, and wherein:
FIG. 1a is a schematic diagram of a conventional solar cell;
FIG. 1b is a top view of the electrode structure of the conventional solar cell;
FIGS. 2a and 2b are schematic diagrams of an electrode structure of a solar cell according to an example not being part of the present invention;
FIG. 3a is a top view of another electrode structure of the solar cell according to an aspect of the present invention;
FIG. 3b is a schematic diagram showing various aspects of the finger electrode according to an aspect of the present invention; and
FIG. 4 is a schematic diagram of another electrode structure of the solar cell according to the embodiment of the present invention.

### DETAILED DESCRIPTION OF THE INVENTION

The present invention will be apparent from the following detailed description, which proceeds with reference to the accompanying drawings, wherein the same references relate to the same elements.

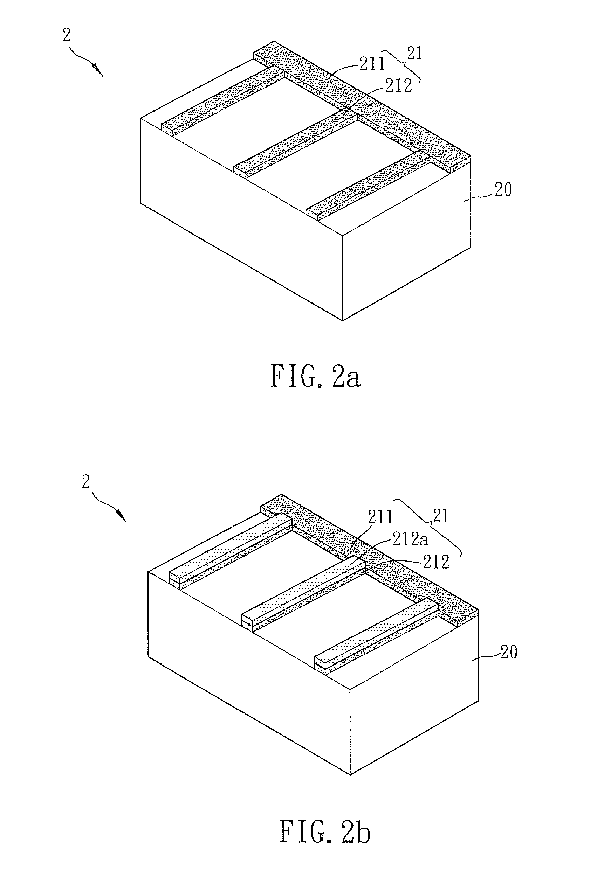

FIGS. 2a and 2b show an electrode structure 21 of a solar cell 2 according to an example not being part of the present invention, wherein only a bus electrode 211 is shown for concise purpose. The solar cell 2 of the embodiment can be a semiconductor solar cell or a thin-film solar cell. With reference to FIGS. 2a and 2b, an electrode structure 21 is disposed on a substrate 20 of a solar cell 2. The electrode structure 21 includes a plurality of bus electrodes 211 and a plurality of finger electrodes 212. The bus electrodes 211 are separately disposed on the substrate 20. The finger electrodes 212 are disposed on two sides of the bus electrodes 211 and electrically connected to the bus electrodes 211. In more detailed, the bus electrodes 211 and the finger electrodes 212 are disposed on the light receiving surface of the substrate 20, and the bus electrodes 211 are substantially disposed in parallel. The width of the finger electrode 212 is smaller than that of any of the bus electrodes 211. In other words, the width of the bus electrode 211 is larger than that of the finger electrode 212, so that the resistance of the bus electrode 211 is obviously smaller than that of the finger electrode 212.

The bus electrodes 211 and the finger electrodes 212 are formed by at least two screen printing processes, and at least one of the screen printing processes does not form the bus electrodes 211. Accordingly, the relative thicknesses of the finger electrodes 212 and the bus electrodes 211 can be controlled. That is, the thickness of the finger electrode 212 is larger than that of the bus electrode 211, so that the resistance of the finger electrodes can be decreased.

The substrate 20 can be a semiconductor substrate, which is made of the semiconductor material with the photo-electro transition function such as the single-crystal silicon substrate, poly-crystal silicon substrate, or As-Ga substrate. In the embodiment, the substrate 20 includes at least one P-type semiconductor layer and at least one N-type semiconductor layer. In addition, an anti-reflective layer is disposed on the surface of the substrate 20 for decreasing the reflection, and a back contact electrode is disposed on the rear surface of the substrate 20 for conducting the solar cell to its load. These additional features are the same as the conventional semiconductor solar cell, so the detailed description thereof will be omitted. Besides, the substrate 20 can be a glass substrate, which includes at least one P-type semiconductor layer, at least one N-type semiconductor layer, and an anti-reflective layer. This feature is the same as the conventional thin-film solar cell, so the detailed description thereof will be omitted.

In order to conduct the electron flow, the bus electrodes 211 and the finger electrodes 212 is usually made of metal. The material of the electrode structure 21 usually includes at least one of silver, tin, and their compounds. Of course, the electrode structure 21 can be made of other conductive materials, and it is not limited in this invention. In addition, the shape, amount and material of the bus electrodes 211 and the finger electrodes 212 can be selectable depending on the dimension of the substrate 20 and any requirement, and it is also not limited in this invention.

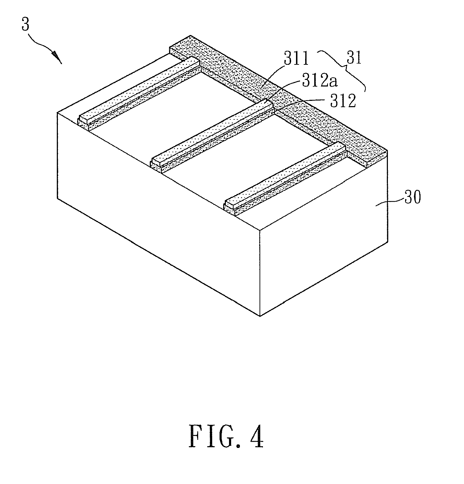

For example, the bus electrodes 211 and the finger electrodes 212 can be formed by screen printing processes, and they are disposed on the light receiving surface of the substrate 20 to form the electrode structure 21. The screen printing process includes at least two steps. The first step is to print the bus electrodes 211 and the finger electrodes 212 on the substrate 20, and cure the printed bus electrodes 211 and finger electrodes 212. The second step is to only print the finger electrodes 212a on the substrate 20 so as to thicken the finger electrodes, and then cure the printed finger electrodes 212a. Accordingly, the thickness of the finger electrodes (212+212a) is larger than that of the bus electrode 211. To be noted, in the present invention, the width of the finger electrodes 212a, 312a is smaller than that of the finger electrodes 212 (see FIG. 4). The finger electrodes formed by two screen printing processes may have the same or different patterns, shapes or dimensions.

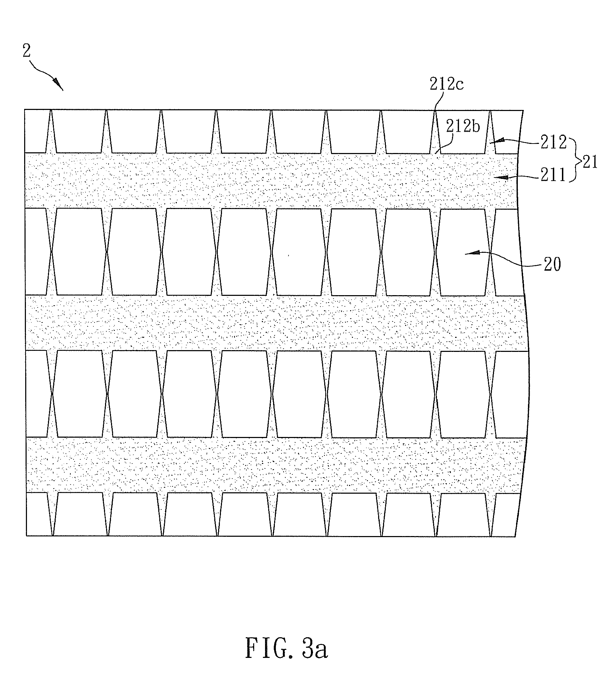

FIG. 3a is a top view of another electrode structure of the solar cell according to an aspect of the present invention, wherein the bus electrodes 211 are substantially disposed in parallel.

In this embodiment, the finger electrodes 212 have a trapezoid shape. In more detailed, each finger electrode 212 has a first end 212b and a second end 212c, and the dimension of the first end 212b is larger than that of the second end 212c. The first end 212b of the finger electrode 212 contacts with one of the bus electrodes 211. Thus, the finger electrode 212 is tapered from the first end 212b to the second end 212c. The second ends 212c of the finger electrodes 212 between two adjacent bus electrodes 211 are connected with each other correspondingly. The bus electrodes 211 and the finger electrodes 212 are substantially perpendicular to each other. The finger electrodes 212 shown in FIG. 3a are for illustration only and are not to limit the scope of the present invention. For example, in the present embodiment, the width of the bus electrode 211 is about 2mm, the first end 212b of the corresponding finger electrodes 212 has a dimension between 60µm and 110µm, and the second end 212c thereof has a dimension between 40µm and 100µm. The difference between the first end 212b and the second end 212c is between 5µm and 70µm. This configuration can efficiently reduce the resistance of the finger electrodes 212.

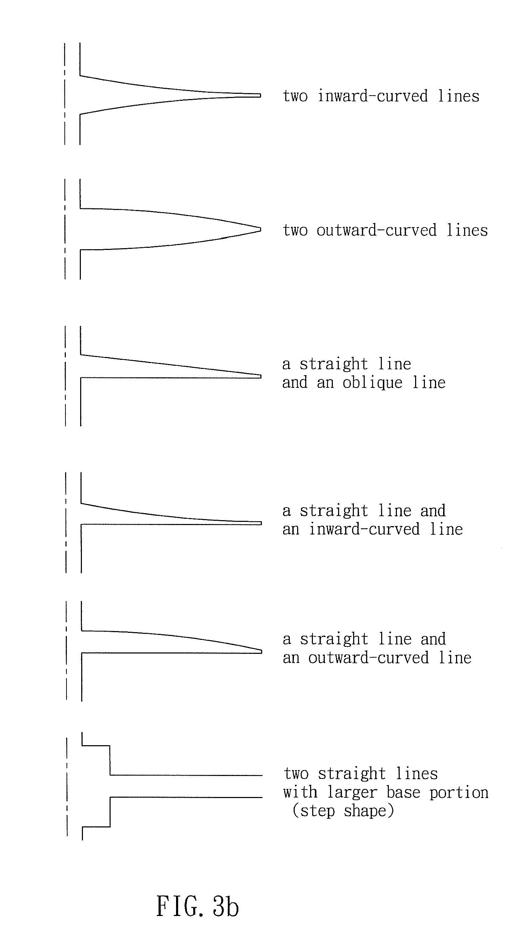

FIG. 3b is a schematic diagram showing various aspects of the finger electrode 212 according to an aspect of the present invention. The aspects of the finger electrode 212 shown in FIG. 3b are only for illustration and are not to limit the scope of the present invention. As shown in FIG. 3b, the finger electrode 212 can be configured by any two of an inward-curved line, an outward-curved line, a straight line, and an oblique line. For example, the finger electrode 212 can be configured by two inward-curved lines, two outward-curved lines, a straight line and an oblique line, a straight line and an inward-curved line, or a straight line and an outward-curved line. Alternatively, the finger electrode 212 can have a step shape. The basic principle for designing the finger electrode is to make the dimension of the first end, which connects to the bus electrode, larger than that of the second end, which is far away from the bus electrode. Any design following this basic principle should be involved in the scope of the present invention.

To sum up, in the electrode structure of the solar cell of the present invention, the bus electrodes and the finger electrodes are formed by at least two screen printing processes, and at least one of the screen printing processes does not form the bus electrodes. Thus, the thickness of the finger electrodes is larger than that of the bus electrodes. The present invention discloses a modified screen printing process to make the thickness of the narrower finger electrode to be larger than that of the wider bus electrode. This feature can decrease the resistance of the finger electrodes and still remain the light obscuring rate. In addition, because at least one of the screen printing processes does not form the bus electrodes, the manufacturing cost of the electrode structure can be reduced. Compared with the prior art, the present invention can achieve the lower light obscuring rate and resistance, thereby efficiently increasing the photo-electro transition rate of the solar cell.

Although the invention has been described with reference to specific embodiments, this description is not meant to be construed in a limiting sense. Various modifications of the disclosed embodiments, as well as alternative embodiments, will be apparent to persons skilled in the art. The scope of the invention is defined by the appended claims.

## Claims

1. An electrode structure, which is disposed on a substrate (30) of a solar cell (3), the electrode structure comprising:
a plurality of bus electrodes (311) separately disposed on the substrate (30); and
a plurality of finger electrodes (312, 312a) disposed on two sides of the bus electrodes (311) and electrically connected to the bus electrodes (311);
wherein said finger electrodes (312, 312a) comprise first finger electrodes (312) and second finger electrodes (312a) disposed on the top of said first finger electrodes (312),
such that the thickness of the finger electrodes (312, 312a) is larger than that of the bus electrodes (311),
**characterised in that** the width of the second finger electrodes (312a) is smaller than the width of the first finger electrodes (312).

2. The electrode structure of claim 1, wherein each of the finger electrodes (212a) has a first end (212b) and a second end (212c), the width of the first end (212b) is larger than that of the second end (212c), and the first ends (212b) of the finger electrodes (212a) contact with one of the bus electrodes (211).

3. The electrode structure of claim 2, wherein the second ends (212c) of the finger electrodes (212a) located between adjacent two of the bus electrodes (211) are connected to each other.

4. The electrode structure of claim 2 or 3, wherein a dimension of the first end (212b) is between 60µm and 110µm, a dimension of the second end (212c) is between 40µm and 100µm, and the difference between the dimension of the first end (212b) and the dimension of the second end (212c) is between 5µm and 70µm.

5. The electrode structure of any claim 2 to 4, wherein each of the finger electrodes (212a) has a taper shape with the first end (212b) larger than the second end (212c).

6. The electrode structure of claim 5, wherein the finger electrodes (212a) have a trapezoid shape.

7. The electrode structure of any of the preceding claims, wherein the width of the finger electrodes (312, 312a) is smaller than that of any of the bus electrodes (211).

8. The electrode structure of any of the preceding claims, wherein the bus electrodes (311) are substantially disposed in parallel.

9. The electrode structure of any of the preceding claims, wherein the bus electrodes (311) and the finger electrodes (312, 312a) are substantially perpendicular to each other.

10. The electrode structure of any of the preceding claims, wherein the finger electrodes (312, 312a) are formed by at least two screen printing processes to form the same or different patterns, shapes or dimensions.

## Patentansprüche

1. Elektrodenstruktur, die auf einem Substrat (30) einer Solarzelle (3) angeordnet ist, wobei die Elektrodenstruktur umfasst:
eine Mehrzahl von Buselektroden (311), die separat auf dem Substrat (30) angeordnet sind; und
eine Mehrzahl von Fingerelektroden (312, 312a), die separat auf zwei Seiten der Buselektroden (311) angeordnet und elektrisch mit den Buselektroden (311) verbunden sind;
wobei die Fingerelektroden (312, 312a) erste Fingerelektroden (312) und zweite Fingerelektroden (312a) umfassend, die auf der Oberseite der ersten Fingerelektroden (312) angeordnet sind,
so dass die Dicke der Fingerelektroden (312, 312a) größer ist als die der BusElektroden (311),
**dadurch gekennzeichnet, dass** die Breite der zweiten Fingerelektroden (312a) kleiner ist als die Breite der ersten Fingerelektroden (312).

2. Elektrodenstruktur nach Anspruch 1, wobei jede der Fingerelektroden (212a) ein erstes Ende (212b) und ein zweites Ende (212c) aufweist, die Breite des ersten Endes (212b) größer ist als die des zweiten Endes (212 c) und die ersten Enden (212b) der Fingerelektroden (212a) mit einer der Buselektroden (211) in Kontakt stehen.

3. Elektrodenstruktur nach Anspruch 2, wobei die zweiten Enden (212c) der Fingerelektroden (212a) die zwischen benachbarten zwei der Buselektroden (211) angeordnet sind, miteinander verbunden sind.

4. Elektrodenstruktur nach Anspruch 2 oder 3, wobei eine Abmessung des ersten Endes (212b) zwischen 60 µm und 110 µm liegt, eine Abmessung des zweiten Endes (212c) zwischen 40 µm und 100 µm liegt und die Differenz zwischen den Abmessungen des ersten Endes (212b) und des zweiten Endes (212c) zwischen 5 µm und 70 µm beträgt.

5. Elektrodenstruktur nach einem der Ansprüche 2 bis 4, wobei jede der Fingerelektroden (212a) eine konische Form hat, wobei das erste Ende (212b) größer ist als das zweite Ende (212c).

6. Elektrodenstruktur nach Anspruch 5, wobei die Fingerelektroden (212a) eine Trapezform haben.

7. Elektrodenstruktur nach einem der vorhergehenden Ansprüche, wobei die Breite der Fingerelektroden (312, 312a) kleiner ist als die von jeder der Buselektroden (211).

8. Elektrodenstruktur nach einem der vorhergehenden Ansprüche, wobei die Buselektroden (311) im Wesentlichen parallel zueinander angeordnet sind.

9. Elektrodenstruktur nach einem der vorhergehenden Ansprüche, wobei die Buselektroden (311) und die Fingerelektroden (312, 312a) im Wesentlichen senkrecht zueinander sind.

10. Elektrodenstruktur nach einem der vorhergehenden Ansprüche, wobei die Fingerelektroden (312, 312a) durch wenigstens zwei Siebdruckverfahrensschritte ausgebildet sind, um gleiche oder verschiedene Muster, Formen oder Abmessungen auszubilden.

## Revendications

1. Une structure d'électrode, disposée sur un substrat (30) d'une cellule solaire (3), la structure d'électrode comprenant :
une pluralité d'électrodes de bus (311) disposées de manière séparées sur le substrat (30) ; et
une pluralité d'électrodes de doigt (312, 312a) disposées sur deux côtés des électrodes de bus (311) et électriquement connectées aux électrodes de bus (311) ;
dans laquelle lesdites électrodes de doigt (312, 312a) comportent des premières électrodes de doigt (312) et des secondes électrodes de doigt (312a) disposées sur le dessus desdites premières électrodes de doigts (312),
de façon à ce que l'épaisseur des électrodes de doigt (312, 312a) est plus grande que celle des électrodes de bus (311),
**caractérisée en ce que** l'épaisseur des secondes électrodes de doigt (312a) est plus petite que l'épaisseur des premières électrodes de doigt (312).

2. La structure d'électrode de la revendication 1, dans laquelle chacune des électrodes de doigt (212a) présente une première extrémité (212b) et une seconde extrémité (212c), la largeur de la première extrémité (212b) étant plus importante que celle de la seconde extrémité (212c), et les premières extrémités (212b) des électrodes de doigt (212a) sont en contact avec l'une des électrodes de bus (211).

3. La structure d'électrode de la revendication 2, dans laquelle sont connectées l'une à l'autre les secondes extrémités (212c) des électrodes de doigt (212a) situées entre deux électrodes de bus adjacentes (211).

4. La structure d'électrode de la revendication 2 ou 3, dans laquelle une dimension de la première extrémité (212b) est comprise entre 60µm et 110µm, une dimension de la seconde extrémité (212c) étant comprise entre 40µm et 100µm, et la différence entre la dimension de la première extrémité (212b) et de la dimension de la seconde extrémité (212c) est comprise entre 5µm et 70µm.

5. La structure d'électrode de l'une quelconque des revendications 2 à 4, dans laquelle chacune des électrodes de doigt (212a) présente une forme de bande avec la première extrémité (212b) plus importante que la seconde extrémité (212c).

6. La structure d'électrode de la revendication 5, dans laquelle les électrodes de doigt (212a) présentent une forme trapézoïdale.

7. La structure d'électrode de l'une quelconque des revendications précédentes, dans laquelle la largeur des électrodes de doigt (312, 312a) est plus petite que celle de l'une quelconque des électrodes de bus (211).

8. La structure d'électrode de l'une quelconque des revendications précédentes, dans laquelle les électrodes de bus (311) sont substantiellement disposées de manière parallèle.

9. La structure d'électrode de l'une quelconque des revendications précédentes, dans laquelle les électrodes de bus (311) et les électrodes de doigt (312, 312a) sont substantiellement perpendiculaires l'une à l'autre.

10. La structure d'électrode de l'une quelconque des revendications précédentes, dans laquelle les électrodes de doigt (312, 312a) sont formées par au moins deux procédés d'impression d'écran pour former des motifs de forme et de dimensions similaires ou différents.
